# EUROPÄISCHE PATENTSCHRIFT

(11) **EP 2 281 315 B1**
(45) Veröffentlichungstag und Bekanntmachung des Hinweises auf die Patenterteilung: **17.10.2018**
(21) Anmeldenummer: 09753511.6
(22) Anmeldetag: 20.04.2009
(51) Int. Cl.: H01L 33/58, H01L 33/54, H01L 25/04, H01L 25/075, H01L 33/38, H01L 33/60, H01L 33/62

(54) **HALBLEITERANORDNUNG**
SEMICONDUCTOR ARRANGEMENT
DISPOSITIF SEMICONDUCTEUR

(30) Priorität: 29.05.2008 DE 102008025756
(43) Veröffentlichungstag der Anmeldung: 09.02.2011
(73) Patentinhaber: OSRAM Opto Semiconductors GmbH, 93055 Regensburg (DE)
(72) Erfinder: ZEILER, Thomas, 93152 Nittendorf (DE); WINDISCH, Reiner, 93186 Pettendorf (DE); GRUBER, Stefan, 93077 Bad Abbach (DE); KIRSCH, Markus, 93164 Brunn (DE); MUSCHAWECK, Julius, 82131 Gauting (DE); BAADE, Torsten, 93059 Regensburg (DE); BRUNNER, Herbert, 93161 Sinzing (DE); KÖHLER, Steffen, 10250 Penang (MY)
(74) Vertreter: Epping - Hermann - Fischer
(86) Internationale Anmeldenummer: PCT/DE2009/000542
(87) Internationale Veröffentlichungsnummer: WO 2009/143795

(56) Entgegenhaltungen:
- EP-A- 1 191 608
- WO-A-2006/114745
- JP-A- 2001 203 396
- US-A- 5 216 805
- US-A1- 2004 061 120
- US-A1- 2005 093 430
- US-A1- 2005 269 582
- US-A1- 2005 280 016
- US-A1- 2006 175 625
- US-A1- 2007 138 494
- US-A1- 2008 116 467
- US-B1- 6 345 903

## Beschreibung

Es wird eine Halbleiteranordnung mit einem optoelektronischen Halbleiterchip angegeben.

Optoelektronische Halbleiterchips etwa in Form von Photodioden oder von Leuchtdioden haben in den letzten Jahren eine weite Verbreitung gefunden. Einige Aspekte, die der Verbreitung optoelektronischer Halbleiterchips Vorschub leisten, sind deren hohe Effizienz, Robustheit gegen äußere Umwelteinflüsse wie beispielsweise Feuchtigkeit oder mechanische Belastung, große Lebensdauer, kompakte Bauweise und vielfältige Ausgestaltungsmöglichkeiten, und dies bei vergleichsweise günstigen Herstellungskosten. Oft entscheidend für diese Eigenschaften ist die Hausung des Halbleiterchips, auf die daher in der Regel großes Augenmerk gelegt wird.

Einige Anwendungsbereiche, in denen optoelektronische Halbleiterchips und insbesondere Leucht- und Laserdioden, eine vorherrschende Stellung einnehmen, sind etwa die Hinterleuchtungen von Displays oder Anzeigeeinrichtungen. Zunehmend finden optoelektronische Halbleiterchips auch Verwendung in Beleuchtungseinrichtungen zu Projektionszwecken, in Scheinwerfern oder Richtstrahlern, oder bei der Allgemeinbeleuchtung.

In der Druckschrift JP 2001-203396 A ist ein Licht emittierendes Bauteil angegeben.

Die Druckschrift US 2005/0280016 A1 betrifft eine PCBbasierte, oberflächenmontierbare Leuchtdiode.

Eine oberflächenmontierbare Leuchtdiode ist in der Druckschrift US 6,345,903 B beschrieben.

In der Druckschrift US 2006/0175625 A1 findet sich ein Licht emittierendes Element.

Eine lumineszierende Keramik für Leuchtdioden findet sich in der Druckschrift US 2005/0269582 A1.

Die Druckschrift US 2007/0138494 A1 betrifft ein Licht emittierendes Bauteil.

Eine Weißlichtquelle wird in der Druckschrift US 2005/0093430 A1 offenbart.

In der Druckschrift US 2008/0116467 A1 ist eine Leuchtdiode mit einer lumineszierenden Keramik wiedergegeben.

Eine Leuchtdiode mit verbesserter Lichtauskopplung ist in der Druckschrift EP 1 191 608 A2 angegeben.

Eine zu lösende Aufgabe besteht darin, eine Halbleiteranordnung anzugeben, die besonders gute optische Eigenschaften aufweist sowie nur einen geringen Platzbedarf aufweist.

Die Halbleiteranordnung weist eine Montageseite auf, über die die Halbleiteranordnung an einem externen, nicht zur Halbleiteranordnung gehörenden Träger, wie etwa einer Platine oder einer Keramik, verbunden wird.

Die Halbleiteranordnung umfasst mindestens einen optoelektronischen Halbleiterchip. Der Halbleiterchip weist eine Chipober- und -unterseite auf, die im Wesentlichen einander gegenüberliegen. Der Halbleiterchip umfasst beispielsweise eine Leucht- oder Laserdiode, die Licht etwa im nahen UV-, im sichtbaren oder im nahinfraroten Spektralbereich emittiert. Ebenso möglich ist es, dass der Halbleiterchip beispielsweise als Sensor etwa in Form einer Photodiode beispielsweise für sichtbares oder nahinfrarotes Licht ausgestaltet ist.

Der Halbleiterchip ist als Flip-Chip oder als Dünnfilm-Chip konzeptioniert. Die Kontaktstellen des Chips, über die dieser elektrisch kontaktiert wird, beschränken sich auf die Chipunterseite.

Die Halbleiteranordnung umfasst einen zumindest teilweise strahlungsdurchlässigen Körper. Das heißt, der Körper ist für mindestens einen Teil der vom Halbleiterchip zu empfangenden oder zu emittierenden Strahlung transparent oder durchlässig. Der Körper weist eine Körperunterseite auf, an der der Halbleiterchip angebracht ist. Die Chipoberseite des Halbleiterchips ist zumindest Teilen der Körperunterseite zugewendet. Die Körperunterseite kann im Wesentlichen flach ausgestaltet sein oder auch Strukturen, wie etwa Ausnehmungen, aufweisen. Der Halbleiterchip kann in direktem Kontakt zur Körperunterseite stehen oder auch über zumindest eine Zwischenschicht an dieser angebracht sein.

Die Halbleiteranordnung umfasst mindestens zwei elektrische Anschlussstellen, die dazu dienen, den optoelektronischen Halbleiterchip elektrisch zu kontaktieren. Die Anschlussstellen können integraler Bestandteil des Halbleiterchips sein, ebenso können sie als separate Bauteile an den Chip, entweder in direktem Kontakt mit diesem oder mittels eines Zwischenträgers, angebracht sein. Die Anschlussstellen überragen den strahlungsdurchlässigen Körper nicht lateral. Mit anderen Worten stehen die Anschlussstellen in Richtungen längs der Chipunterseite und/oder der Körperunterseite nicht über den strahlungsdurchlässigen Körper hinaus. Das heißt, die größte seitliche Ausdehnung der Halbleiteranordnung, etwa parallel zur Chipunterseite, ist durch den strahlungsdurchlässigen Körper oder durch den Halbleiterchip gegeben. Zudem begrenzen die Anschlussstellen die Halbleiteranordnung in Richtung deren Montageseite. Das heißt, weder strahlungsdurchlässiger Körper noch Halbleiterchip überragen die Anschlussstellen in Richtung Montageseite. Mit anderen Worten ist die Halbleiteranordnung in Richtungen quer zur Chipunterseite und/oder Körperunterseite durch die Anschlussstellen begrenzt.

Die Halbleiteranordnung ist oberflächenmontierbar. Dies bedeutet, dass beim Anschließen der Halbleiteranordnung beispielsweise an einen externen Träger keine Durchkontaktierung durch den externen Träger hindurch, etwa in Form von Lötstiften, notwendig ist. Beim Anschließen wird die Halbleiteranordnung bevorzugt auf eine Oberfläche zum Beispiel des externen Trägers aufgesetzt, ohne diese Oberfläche zu durchdringen, bevor eine mechanische Verbindung zwischen Träger und Halbleiteranordnung etwa mittels Löten oder Kleben erfolgt. Durch eine solche Halbleiteranordnung wird die Montage der Halbleiteranordnung vereinfacht. Außerdem können sich die Arbeitsschritte bei der Gestaltung etwa eines externen Trägers reduzieren.

Die Halbleiteranordnung umfasst eine Montageseite, mindestens einen optoelektronischen Halbleiterchip mit einander gegenüberliegenden Chipober- und Chipunterseiten, sowie mindestens einen zumindest teilweise strahlungsdurchlässigen Körper mit einer Körperunterseite, an der der Halbleiterchip so angebracht ist, dass die Chipoberseite der Körperunterseite zugewandt ist. Des Weiteren umfasst die Halbleiteranordnung mindestens zwei elektrische Anschlussstellen zur elektrischen Kontaktierung des optoelektronischen Halbleiterchips, wobei die Anschlussstellen den Körper lateral nicht überragen und mit ihrer, dem Halbleiterchip abgewandten Seite die Halbleiteranordnung an deren Montageseite begrenzen, und wobei die Halbleiteranordnung oberflächenmontierbar ist.

Durch eine solche Halbleiteranordnung wird es unter anderem ermöglicht, sehr kompakte und Platz sparende Bauteile herzustellen, beispielsweise weil die laterale Ausdehnung der Halbleiteranordnung durch die laterale Ausdehnung des strahlungsdurchlässigen Körpers begrenzt sein kann. Durch die geringe Anzahl an Komponenten der Halbleiteranordnung kann auch deren Herstellung effizient gestaltet und mit reduzierten Herstellungskosten stattfinden. Zugleich wird gewährleistet, dass die konkrete Ausgestaltung der Halbleiteranordnung flexibel gehandhabt werden kann.

Bei der Halbleiteranordnung ist der Halbleiterchip mit dem vorgefertigten strahlungsdurchlässigen Körper mit einer mindestens teilweise strahlungsdurchlässigen Klebeverbindung verbunden. Es ist durch die Klebeverbindung eine permanente Verbindung zwischen Halbleiterchip und Körper gegeben. Das heißt, unter normalen Betriebsbedingungen löst sich die Klebeverbindung während der Lebenszeit der Halbleiteranordnung nicht. Klebverbindungen sind technisch leicht zu realisieren. Deren mechanische Eigenschaften und geometrische Abmessungen lassen sich in einem weiten Parameterbereich einstellen. Umfasst die Klebeverbindung zumindest zum Teil etwa ein Silikon, das auch in ausgehärtetem Zustand eine gewisse mechanische Flexibilität besitzt, so können thermische Spannungen, die durch den Betrieb des optoelektronischen Halbleiterchips verursacht sind, gegenüber dem strahlungsdurchlässigen Körper gepuffert werden. Die Dicke der Klebeverbindung kann, je nach konkreten Erfordernissen der angestrebten Anwendung, von wenigen Mikrometern bis zu einigen hundert Mikrometern betragen. Weitere mögliche Materialien für die Klebeverbindung sind Epoxidharze sowie Hybridmaterialien aus Epoxid und Silikon. Ebenso wie der strahlungsdurchlässige Körper ist die Klebeverbindung bevorzugt alterungsbeständig gegenüber Strahlungs- und Temperaturbelastungen, die sich aus dem Betrieb der Halbleiteranordnung ergeben.

Es ist die Chipunterseite frei von einer Klebeverbindung. Das heißt, die Klebeverbindung beschränkt sich auf die Chipoberseite und auf die Seitenflächen des Chips. Als Seitenflächen sind hierbei die zur Chipunter- beziehungsweise -oberseite beispielsweise senkrecht ausgerichteten Begrenzungsflächen des Halbleiterchips bezeichnet, die die Chipober- und Chipunterseite miteinander verbinden. Durch eine solche Klebeverbindung ist ein guter mechanischer und optischer Kontakt zwischen Halbleiterchip und strahlungsdurchlässigen Körper gewährleistet, und der Halbleiterchip selbst ist durch Klebeverbindung und/oder Körper vor äußeren Einflüssen gut geschützt.

In einer Abwandlung der Halbleiteranordnung beschränkt sich die Klebeverbindung auf die Chipoberseite. Dies hat zur Konsequenz, dass die Seitenflächen des Halbleiterchips frei von der Klebeverbindung sind, so dass lateral besonders wenig Platz einnehmende Halbleiteranordnungen ermöglicht werden.

Gemäß zumindest einer Ausführungsform der Halbleiteranordnung sind deren Anschlussstellen SMT-kontaktierbar ausgestaltet. Surface mount technology, kurz SMT, ist eine Technologie, um elektronische Bauteile mit kleinen Abmessungen, das heißt mit lateralen Ausdehnungen in der Größenordnung 1 mm, mit einem Träger, wie etwa einer Platine, elektrisch zu kontaktieren beziehungsweise an diesem zu befestigen. Bevorzugt sind die Anschlussstellen mit einem Metall gestaltet, das über Löten verbindbar ist. Ebenso bevorzugt ist die Halbleiteranordnung so ausgeführt, dass sie gegenüber den bei einem Lötprozess auftretenden thermischen Belastungen beständig ist. Eine Halbleiteranordnung, die mit derartigen Anschlussflächen SMTverarbeitbar ist, erlaubt einen großen Anwendungs- und Einsatzbereich. Außerdem ist die SMT-Kontaktierung eine besonders effiziente und kostengünstige Möglichkeit, die Halbleiteranordnung auch im Verbund mit anderen elektronischen Komponenten, beispielsweise mittels Löten durch Erhitzen in einem Ofen, an einem Träger zu befestigen beziehungsweise elektrisch zu kontaktieren, insbesondere da im Regelfall keine Durchkontaktierungen durch den Träger hindurch erforderlich sind.

Die Anschlussstellen überragen den Halbleiterchip lateral, das heißt in Richtung parallel zur Chipunterseite, nicht. Durch eine solche Ausgestaltung der Anschlussflächen können besonders kompakte Halbleiteranordnungen realisiert werden und hochdichte Packungen von Halbleiteranordnungen auf einem Träger, zum Beispiel einer Metallkernplatine, sind ermöglicht.

Gemäß zumindest einer Ausführungsform der Halbleiteranordnung sind die Anschlussstellen direkt an der Chipunterseite angebracht. Die Anschlussstellen können einstückig mit dem Halbleiterchip ausgestaltet und integraler Bestandteil des Chips sein, so dass die Anschlussstellen bereits im Herstellungsprozess des Halbleiterchips selbst mit gefertigt sind. Mögliche Materialien für die Anschlussstellen sind Metalle, die ein relativ leichtes Kontaktieren der Anschlussstellen über Lötprozesse ermöglichen und die gleichzeitig auch als reflektierende Flächen für die vom Halbleiterchip emittierte oder von diesem zu empfangende Strahlung dienen können. Weiterhin ist es möglich, dass die Anschlussstellen aus einem transparenten Material, etwa einem Metalloxid wie Indium-Zinn-Oxid, kurz ITO, gefertigt sind, so dass diese für die vom Halbleiterchip zu empfangende oder von diesem abgestrahlte Strahlung im Wesentlichen durchlässig ausgestaltet sind.

Darüber hinaus sind die Anschlussstellen vorzugsweise im Wesentlichen parallel zur Chipunterseite ausgerichtet. Durch die im Rahmen der Fertigungsgenauigkeit parallele Ausrichtung der Anschlussstellen zum Halbleiterchip kann eine in vertikaler Richtung besonders Platz sparende Anordnung erzielt werden.

Ferner sind die Anschlussstellen bevorzugt flächig ausgestaltet. Sind die Anschlussstellen flächig ausgestaltet, bedecken sie insbesondere einen Teil der Unterseite des Halbleiterchips Beispielsweise bedecken die Anschlussstellen dann wenigstens 40%, vorzugsweise wenigstens 70%, besonders bevorzugt wenigstens 90% der Chipunterseite. Auf diese Weise ist ein guter elektrischer und thermischer Kontakt zwischen Halbleiterchip und einem externen Träger gewährleistet. Außerdem erleichtern großflächige Anschlussstellen die Kontaktierung der Halbleiteranordnung, da die Fertigungstoleranzen für die Kontaktierung dann entsprechend größer sind.

Bei der Halbleiteranordnung ist die Körperunterseite mit einer Ausnehmung versehen, in der sich der Halbleiterchip zumindest teilweise befindet, das heißt, der Halbleiterchip kann aus der Ausnehmung in Richtung Körperunterseite herausragen beziehungsweise die Ausnehmung teilweise lateral überragen. Die durch die Ausnehmung gebildeten Begrenzungsflächen des Körpers werden als zur Körperunterseite gehörig betrachtet. Zudem kann der Körper den Halbleiterchip mit Ausnahme dessen Unterseite allseitig umgeben. Durch eine solche Ausnehmung kann der Halbleiterchip etwa besonders einfach und genau relativ zum strahlungsdurchlässigen Körper positioniert werden.

Es weicht die laterale Ausdehnung des strahlungsdurchlässigen Körpers um weniger als 40% von der lateralen Ausdehnung des Halbleiterchips ab, bevorzugt weniger als 20%, besonders bevorzugt weniger als 10%. Die Abweichung der lateralen Ausdehnungen voneinander ist hierbei definiert durch das Verhältnis der Abmessung des Körpers in einer Richtung parallel zur Chipunterseite, bezogen auf die Abmessung des Halbleiterchips in derselben Richtung, wobei alle Richtungen parallel zur Chipunterseite zu betrachten sind. Über den strahlungsdurchlässigen Körper wird der Halbleiterchip mechanisch stabilisiert, so dass eine einfache Handhabung, insbesondere Positionierung, der Halbleiteranordnung etwa mit Pinzetten oder anderen Werkzeugen ermöglicht ist.

Gemäß zumindest einer Ausführungsform der Halbleiteranordnung ist die Chipunterseite zumindest stellenweise frei zugänglich. Das heißt, dass die Chipunterseite beispielsweise nicht an ein Gehäuse der Halbleiteranordnung grenzt. Dies ermöglicht eine besonders leichte Handhabung im Rahmen späterer Fertigungs- und Montageprozesse. Auch ist es durch eine solche Anordnung möglich, eventuelle Fehlfunktionen der Halbleiteranordnung zu diagnostizieren und gegebenenfalls zu beheben.

Gemäß zumindest einer Ausführungsform der Halbleiteranordnung ist die Klebeverbindung für die vom Halbleiterchip emittierte oder zu empfangende Strahlung durchlässig, das heißt die Klebeverbindung absorbiert im relevanten Spektralbereich nicht signifikant. Das heißt, mindestens 80% der Strahlung wird von der Klebeverbindung transmittiert, bevorzugt mehr als 95%. Durch eine solche Ausgestaltung der Klebeverbindung wird ein besonders effizientes Bauteil ermöglicht.

Gemäß zumindest einer Ausführungsform der Halbleiteranordnung umfasst die Klebeverbindung ein Filtermittel, das einen Teil der vom Halbleiterchip emittierten oder zu empfangenden Strahlung absorbiert. Insbesondere wenn der Halbleiterchip als ein Sensor ausgestaltet ist, kann durch ein passendes Filtermittel der freie Spektralbereich je nach Anforderung eingeschränkt werden, so dass der Halbleiterchip etwa nur schmalbandig nahinfrarote Strahlung empfängt. Filtermittel können sein Pigmente oder Farbstoffe, die der Klebeverbindung beigegeben werden. Es können auch etwa mehrere Farbstoffe miteinander kombiniert werden. Da eine große Auswahl an Pigmenten beziehungsweise Farbstoffen zur technischen Verwendung zur Verfügung steht, bietet dies eine einfach zu realisierende Möglichkeit, ein Filtermittel in der Halbleiteranordnung zu integrieren.

Gemäß zumindest einer Ausführungsform der Halbleiteranordnung enthalten Klebeverbindung oder strahlungsdurchlässiger Körper Streumittel, die auf die vom Halbleiterchip emittierte oder zu empfangende Strahlung streuend wirken. Solche Streumittel können etwa mit Aluminiumoxid oder Titandioxid gebildet sein. Klebeverbindung oder Körper sind dann etwa milchig ausgestaltet und wirken als Diffusor, so dass die Strahlung gleichmäßig, etwa ähnlich einem Lambert'schen Strahlen, von der Oberfläche der Halbleiteranordnung abstrahlt wird. Auch eine punktuelle Belastung des Halbleiterchips, falls dieser beispielsweise als Photodiode ausgestaltet ist, wird unterbunden, so dass sich eine gleichmäßigere Ausleuchtung des Halbleiterchips und damit beispielsweise ein besseres Signal-zu-Rausch-Verhältnis ergibt.

Gemäß zumindest einer Ausführungsform der Halbleiteranordnung umfassen strahlungsdurchlässiger Körper oder Klebeverbindung ein Konversionsmittel, das mindestens einen Teil der vom Halbleiterchip emittierten oder zu empfangenden Strahlung in eine Strahlung einer anderen Frequenz konvertiert. Solche Konversionsmittel können etwa Lumineszenzleuchtstoffe sein. Über solche Leuchtstoffe ist es möglich, etwa das Licht eines blau emittierenden Halbleiterchips in im Wesentlichen weißes Licht zu konvertieren. Ebenso ist es möglich, dass das Konversionsmittel etwa mit einem Kristall gestaltet ist, das die vom Halbleiterchip emittierte Strahlung etwa Frequenz verdoppelt oder verdreifacht. Des Weiteren kann das Konversionsmittel auch mit einem photonischen Kristall oder einem ähnlich wirkenden optisch aktiven Medium gestaltet sein. Beispielsweise durch die Verwendung von Konversionsmitteln ist es möglich, effiziente kostengünstige Bauteile wie etwa blau emittierende Leuchtdioden auf GaN-Basis zu verwenden, um etwa für eine Beleuchtungseinrichtung Strahlung auch abstimmbar im nahezu gesamten sichtbaren Spektralbereich zu erzeugen.

Gemäß zumindest einer Ausführungsform der Halbleiteranordnung ist zumindest einer der Beimengungen, beispielsweise das Konversionsmittel, inhomogen im strahlungsdurchlässigen Körper oder in der Klebeverbindung verteilt. Das heißt, an verschiedenen Orten im Körper beziehungsweise in der Klebeverbindung liegt eine andere Konversionsmittelkonzentration vor. Beispielsweise kann der strahlungsdurchlässige Körper in den lateral mittleren Bereichen über dem Halbleiterchip eine höhere Konversionsmittelkonzentration aufweisen als in den Randbereichen. Durch eine höhere Konversionsmittelkonzentration über der Mitte des Halbleiterchips kann, falls der Halbleiterchip etwa als LED ausgestaltet ist, eine besonders gleichmäßige spektral homogene Abstrahlung der Halbleiteranordnung über die gesamte Oberfläche des strahlungsdurchlässigen Körpers hin gewährleistet werden. Innerhalb des Körpers oder der Klebeverbindung können auch verschiedene Beimengungen, wie etwa Konversions-, Filter- oder Streumittel, untergebracht sein. Ebenso kann etwa der Körper etwa eine andere Beimengung enthalten als die Klebeverbindung.

Gemäß zumindest einer Ausführungsform der Halbleiteranordnung weist die Klebeverbindung eine inhomogene Dicke auf. Die Klebeverbindung, in der zum Beispiel mit einer konstanten Konzentration ein Konversionsmittel beigemengt ist, weist etwa über dem lateral mittleren Bereich der Chipoberseite eine größere Dicke auf als an den Randbereichen. Durch eine solche Anordnung kann wiederum eine spektral homogene Abstrahlung der Halbleiteranordnung über deren gesamte Oberseite gewährleistet werden. Über die Formgebung des strahlungsdurchlässigen Körpers, insbesondere über die Form einer Ausnehmung, in der sich der Halbleiterchip befinden kann, ist eine solche inhomogene Dicke einfach generierbar.

Gemäß zumindest einer Ausführungsform der Halbleiteranordnung ist der optische Brechungsindex der Klebeverbindung kleiner als der des Körpers. Ist der Halbleiterchip als Leuchtdiode ausgestaltet, welche zum Beispiel Materialien wie Gallium-Nitrid oder Phosphor-Nitrid umfasst, so ist der Brechungsindex des Halbleiterchips typischerweise relativ groß und beträgt in der Regel zwischen 2 und 3. Der optische Brechungsindex von Silikonen oder Epoxiden beträgt, je nach Zusammensetzung, im Bereich zwischen 1,4 und 1,7. Der Brechungsindex der Klebeverbindung kann also im Normalfall so eingestellt werden, dass er kleiner ist als der des Halbleiterchips und der des strahlungsdurchlässigen Körpers. Da der Brechungsindex der Klebeverbindung kleiner ist als der des Körpers, erfährt vom Halbleiterchip emittiertes Licht an der Grenzfläche zwischen Klebeverbindung und Körper eine Wirkung ähnlich wie bei einer Sammellinse.

Gemäß zumindest einer Ausführungsform der Halbleiteranordnung ist der strahlungsdurchlässigen Körper linsenartig ausgestaltet. Linsenartig bedeutet, dass die vom Halbleiterchip abgewandte Oberfläche, oder zumindest ein Teil dieser, etwa die Form einer Konkav- oder Konvexlinse aufweist. Die Form muss hierbei nicht genau der einer Linse entsprechen. Die Linse muss zudem nicht sphärisch beziehungsweise rotationssymmetrisch ausgeprägt sein, sondern kann auch in Form etwa einer Zylinderlinse ausgestaltet sein. Ebenso ist es möglich, dass "flache" Geometrien wie etwa Fresnel-Linsen Verwendung finden.

Gemäß zumindest einer Ausführungsform der Halbleiteranordnung ist auf dem strahlungsdurchlässigen Körper zumindest teilweise zumindest eine reflektierende Schicht aufgebracht. Die reflektierende Schicht kann auch nur für einen bestimmten Spektralbereich reflektierend wirken oder auch semitransparent ausgestaltet sein. Speziell ist es möglich, sofern der Körper nur teilweise beschichtet ist und die Körperoberseite entsprechend ausgeformt ist, dass sich eine Halbleiteranordnung ergibt, die hauptsächlich in Richtung senkrecht zur Chipoberseite Strahlung emittiert.

Gemäß zumindest einer Ausführungsform der Halbleiteranordnung ist der Halbleiterchip an mindestens einem Zwischenträger angebracht. Der Zwischenträger kann etwa mit einer Keramik oder mit einer Umverdrahtungsebene gestaltet sein. Über eine solche Anordnung kann der Halbleiterchip vollständig verkapselt und somit sehr gut gegen Umwelteinflüsse geschützt werden. Auch ist es auf diese Weise besonders einfach möglich, mehrere Halbleiterchips in der Halbleiteranordnung unterzubringen.

Gemäß zumindest einer Ausführungsform der Halbleiteranordnung umfasst diese bis auf den Halbleiterchip, den strahlungsdurchlässigen Körper und die Anschlussstellen keine weiteren Komponenten mehr. Beimengungen in Klebeverbindung beziehungsweise Körper sind hierbei jedoch nicht ausgeschlossen. Eine Beschränkung auf diese Komponenten ermöglicht es, besonders effizient Halbleiteranordnungen herzustellen.

Gemäß zumindest einer Ausführungsform der Halbleiteranordnung sind strahlungsdurchlässiger Körper und Halbleiterchip separat gefertigt. Der strahlungsdurchlässige Körper kann mittels Gießen, Spritzgießen, Druckgießen, Flüssigspritzgießen, Flüssigdruckpressen oder Formpressen hergestellt sein. Der Halbleiterchip kann epitaktisch gewachsen sein und ist vor der Montage bevorzugt von einem Aufwachssubstrat separiert. Besonders bevorzugt liegen die Halbleiterchips vereinzelt vor.

Das Zusammenfügen von Halbleiterchip und Körper kann folgende Schritte aufweisen:
- Bereitstellen beziehungsweise Herstellen des Körpers,
- Bereitstellen beziehungsweise Herstellen des Halbleiterchips,
- Platzieren des Körpers derart, dass dessen Körperunterseite nach oben weist,
- Aufbringen eines die Klebeverbindung ausbildenden Materials auf die Körperunterseite, wobei die Körperunterseite in vertikaler Richtung nach oben weist, und
- Aufbringen beziehungsweise Eindrücken des Halbleiterchips in das die Klebeverbindung bildende Material, wobei die Chipoberseite der Körperunterseite zugewandt ist.

Bevorzugt weist das Material, das die Klebeverbindung bildet, beim Aufbringen des Halbleiterchips eine zähflüssige Konsistenz auf. Optional kann auf der Chipunterseite, die dem Körper abgewandt ist, eine Schutzfolie oder Schutzschicht aufgebracht sein, so dass der Halbleiterchip während des Aufbringens beziehungsweise Eindrückens nicht beschädigt und/oder etwa vom Material nicht benetzt wird.

Nachfolgend wird die beschriebene Halbleiteranordnung unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt. Vielmehr können einzelne Elemente zum besseren Verständnis übertrieben groß dargestellt sein.

Es zeigen:
Figur 1 eine schematische Seitenansicht einer Abwandlung einer Halbleiteranordnung,
Figur 2 eine schematische Seitenansicht eines Ausführungsbeispiels einer Halbleiteranordnung,
Figur 3 eine schematische Schnittdarstellung einer Abwandlung einer Halbleiteranordnung mit inhomogener Dicke der Klebeverbindung,
Figur 4 eine schematische Schnittdarstellung einer weiteren Abwandlung,
Figur 5a, b eine schematische Schnittdarstellung einer Abwandlung mit einer auf dem strahlungsdurchlässigen Körper angebrachten reflektierenden Schicht,
Figur 6 eine schematische Schnittdarstellung einer Abwandlung mit mehreren Halbleiterchips,
Figur 7 eine schematische Schnittdarstellung einer Abwandlung mit einem Zwischenträger, und
Figur 8 eine schematische Seitenansicht einer Anordnung von Abwandlungen mehrerer Halbleiteranordnungen auf einem Träger.

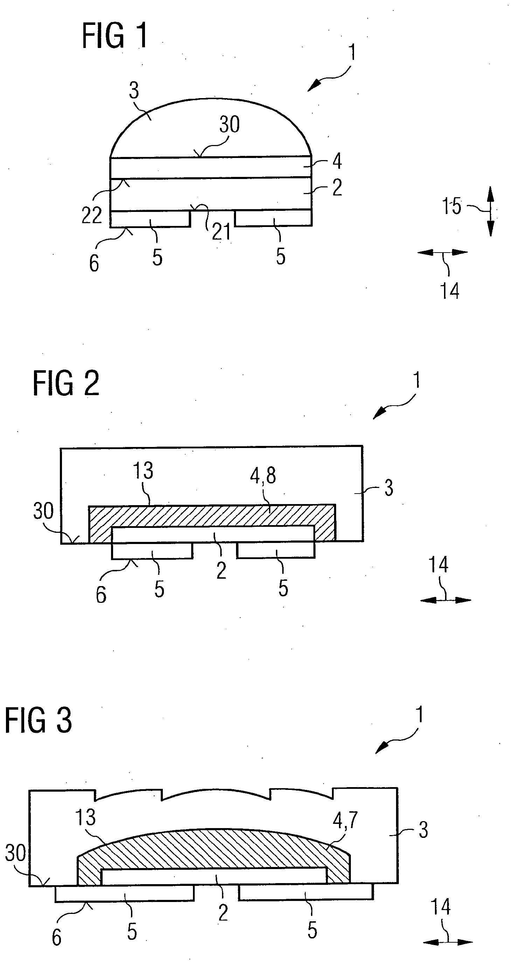

In Figur 1 ist eine Abwandlung einer Halbleiteranordnung 1 gezeigt. Der Halbleiterchip 2 ist als eine blau emittierende auf GaN basierte Leuchtdiode ausgestaltet. Für die geometrischen Abmessungen des Halbleiterchips 2 gibt es keine strikten Begrenzungen. Vorzugsweise beträgt die Ausdehnung in lateraler Richtung 14, das heißt parallel zur Chipunterseite 21, etwa 0,5 bis 3 mm² und dessen Dicke 50 bis 300 µm. An der Chipunterseite 21 sind zwei elektrische Anschlussstellen 5 angebracht. Die Anschlussstellen 5 sind in direktem Kontakt mit der Chipunterseite 21. Die Chipoberseite 22 ist mit einer Klebeverbindung 4 bedeckt, welche Halbleiterchip 2 und strahlungsdurchlässigen Körper 3 permanent mechanisch miteinander verbindet. Die Klebeverbindung 4 ist mit einem transparenten, bezüglich der vom Halbleiterchip 2 emittierten Strahlung alterungsbeständigen Material ausgestaltet, wie zum Beispiel Silikon oder einem Silikon-Epoxid-Hybridmaterial. Der Körper 3 ist in Form ähnlich einer Konvexlinse sphärisch ausgestaltet und für die vom Halbleiterchip 2 emittierte Strahlung durchlässig.

Eine einfach Möglichkeit, einen solchen Körper 3 zu produzieren, stellen Gießverfahren wie beispielsweise Compression Molding dar. Das Material des Körpers 3 ist etwa thermoplastisch. Auch Materialien aus der Gruppe der Silikone, Epoxide, Polycarbonate oder Hybridmaterialien können Verwendung finden. Ebenso kann der Körper 3 aus Gläsern hergestellt sein. Bevorzugt ist das Material beständig gegen die von der konkreten Anwendung auferlegten Umwelteinflüsse und alterungsstabil bezüglich der vom Halbleiterchip 2 zu empfangenden oder zu emittierenden Strahlung.

Die Ausdehnung in lateraler Richtung 14 der Halbleiteranordnung 1 ist gleich der Ausdehnung in lateraler Richtung 14 des Halbleiterchips 2, das heißt elektrische Anschlussstellen 5 sowie Klebeverbindung 4 als auch Körper 3 stehen in lateraler Richtung 14, also parallel zur Chipunterseite 21, nicht über den Halbleiterchip 2 über. Auch wird die Halbleiteranordnung 1 von den dem Halbleiterchip 2 abgewandten Seiten der Anschlussstellen 5 bezüglich der Montageseite 6 begrenzt. Die Montageseite 6 ist im Wesentlichen parallel zur Chipunterseite 21 ausgerichtet.

Ein Ausführungsbeispiel der Halbleiteranordnung 1 ist in Figur 2 gezeigt. Die Halbleiteranordnung 1 umfasst in diesem Falle einen Halbleiterchip 2, der beispielsweise als Sensor etwa für nahinfrarote Strahlung ausgestaltet ist. An der Chipunterseite 21 befinden sich zwei metallische Anschlussstellen 5, die über Surface Mount Technology, kurz SMT, an einem nicht gezeichneten, externen Träger mittels etwa Löten oder Kleben angebracht werden können. Die Anschlussstellen begrenzen wiederum die Halbleiteranordnung 1 in Richtung Montageseite 6 nach unten hin. An Chipoberseite 22 und an den Seitenflächen des Halbleiterchips 2 ist eine mit einem transparenten Silikon ausgestaltete Klebeverbindung 4 angebracht. Diese weist ein darin homogen verteiltes Filtermittel 8 auf. Das Filtermittel 8 kann derart gewählt werden, dass höherfrequente sichtbare Strahlungsanteile gefiltert werden, so dass der als Sensor ausgestaltete Halbleiterchip 2 etwa nur für nahinfrarote Strahlung zugänglich ist. Optional kann der Halbleiterchip 2 auch etwa eine Leuchtdiode, die im Betrieb elektromagnetische Strahlung emittiert, sein. Anstelle des Filtermittels 8 kann alternativ oder zusätzlich ein Streu- oder Konversionsmittel 7 verwendet werden.

Der Halbleiterchip 2 weist einen quadratischen Grundriss auf. Der strahlungsdurchlässige Körper 3 weist in Draufsicht einen rechteckigen Querschnitt auf, ist an der Körperunterseite 30 mit einer Ausnehmung 13 versehen und umgibt den Halbleiterchip 2 seitlich an nur zwei einander gegenüberliegenden Seitenflächen, so dass einerseits der Platzbedarf in lateraler Richtung 14 minimiert wird und andererseits der Halbleiterchip 2 in der Ausnehmung 13 des Körpers gut zu positionieren ist. Die Ausnehmung 13 an der Körperunterseite 30 ist derart bemessen, dass der Halbleiterchip in ihr Platz findet und außerdem sich die gewünschte Schichtdicke der Klebeverbindung 4 einstellt. Die Ausnehmung 13 kann bei der Herstellung des Körpers 3, etwa im Rahmen eines Gießverfahrens, einfach erzeugt werden.

Als Material für den strahlungsdurchlässigen Körper 3 ist ein transparentes Silikon verwendet. Die Oberseite des Körpers 3 ist flach geformt und durch die mechanischen Eigenschaften des verwendeten Silikons, das optional eine Beschichtung aufweisen kann, kratzfest ausgestaltet. Hierdurch ergibt sich die Halbleiteranordnung 1 als guter Lambert'scher Strahler. Die elektrischen Anschlussstellen 5 bedecken einen Teil der Chipunterseite 21 und bilden mit der dem Halbleiterchip 2 zugewandten Seite eine für die vom Halbleiterchip 2 zu detektierende oder von diesem emittierte Strahlung reflektierende Fläche aus. Die Anschlussstellen 5 schließen in lateraler Richtung 14 bündig mit dem Halbleiterchip 2 ab. Alternativ können die elektrischen Anschlussstellen 5 auch aus einem transparenten Material etwa aus der Gruppe der Transparent Conductive Oxides, kurz TCO, wie etwa ITO ausgestaltet sein. Dies ist insbesondere von Vorteil, falls der externe Träger, an dem die Halbleiteranordnung 1 angebracht wird, ebenfalls für die relevante Strahlung durchlässig ist.

In Figur 3 ist eine weitere Abwandlung dargestellt. Der Halbleiterchip 2 ist etwa als Laser- oder Leuchtdiode ausgestaltet und emittiert im Betrieb Licht. Die Anschlussstellen 5 ragen in lateraler Richtung 14 über den Halbleiterchip 2 über, nicht aber über den strahlungsdurchlässigen Körper 3. Die dem Halbleiterchip 2 zugewandte Seite der flächig gestalteten Anschlussstellen 5 schließt in vertikaler Richtung 15 bündig mit dem Körper 3 ab. Bis auf die Chipunterseite 21 ist der Halbleiterchip 2 von einer Klebeverbindung 4 umgeben. Über der Chipoberseite 22 weist die Klebeverbindung 4 eine inhomogene Dicke dergestalt auf, dass über dem in lateraler Richtung 14 mittleren Bereich des Halbleiterchips 2 die Dicke größer ist als an den Randbereichen. In der Klebeverbindung 4 ist ein Konversionsmittel 7 in einer über der gesamten Klebeverbindung 4 gleich bleibenden Konzentration eingebracht. Durch die größere Dicke der Klebeverbindung 4 über dem Zentralbereich des Halbleiterchips 2 befindet sich dort ebenfalls eine größere Menge an Konversionsmittel 7, so dass sich insgesamt eine gleichmäßigere Abstrahlung mit einer besseren spektralen Homogenität über die gesamte Chipoberseite 22 ergibt. Die inhomogene Schichtdicke der Klebeverbindung 4 wird automatisch beim Einkleben des Halbleiterchips 2 in den Körper 3 eingestellt, da der aus einem transparenten alterungsbeständigen Material bestehende Körper 3 eine linsenartige Ausnehmung 13 an der Körperunterseite 30 aufweist, in der sich der Halbleiterchip 2 im Wesentlichen befindet. Die Oberseite des strahlungsdurchlässigen Körpers 3 ist als Fresnel-Linse ausgeformt. Der Körper 3 umgibt den Halbleiterchip 2 an allen Seitenflächen.

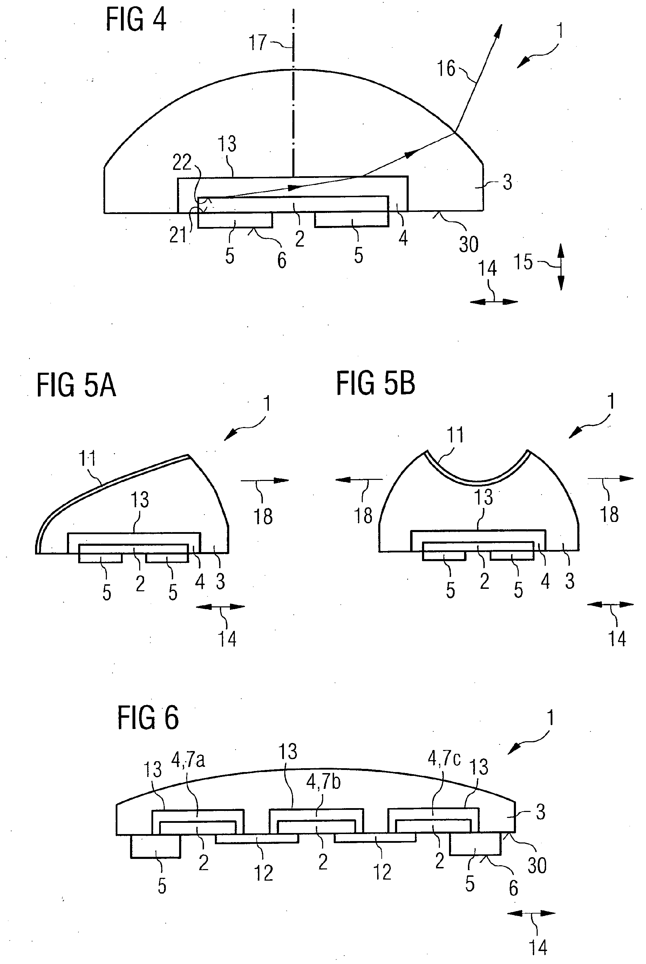

In Figur 4 ist eine weitere Abwandlung dargestellt. Der strahlungsdurchlässige Körper 3 ist in diesem Falle in lateraler Richtung 14 deutlich größer als der sich in einer Ausnehmung 13 an der Körperunterseite 30 befindliche Halbleiterchip 2, um eine höhere Qualität der optischen Abbildung zu erzielen. Die elektrischen Anschlussstellen 5 sind erneut direkt an der Chipunterseite 21 angebracht und überragen den Halbleiterchip 2 nicht in lateraler Richtung 14. Die transparente Klebeverbindung 4 ist mit einem Silikon ausgestaltet, das einen Brechungsindex von etwa 1,4 aufweist. Der als konvexlinsenartig ausgeformte Körper 3 ist mit Polycarbonat mit einem Brechungsindex von etwa 1,6 ausgestaltet, so dass der Brechungsindex der Klebeverbindung kleiner ist als der des Körpers. Der Strahlweg 16 eines vom Halbleiterchip 2 emittierten Photons ist schematisch als gepfeilte Linie eingezeichnet. Das Photon wird am Rand der Chipoberseite 22 emittiert und läuft unter einem kleinen Winkel durch die Klebeverbindung 4. An der Grenzfläche zwischen Klebeverbindung 4 und Körper 3 findet eine Lichtbrechung dergestalt statt, dass das Photon in vertikaler Richtung 15 von der Chipoberseite 22 weg abgelenkt wird. Dadurch können solche Photonen anschließend durch den strahlungsdurchlässigen Körper 3 besser abgebildet werden, da sie auf die Grenzfläche Körper-Luft näher an der optischen Achse des Körpers 3 auftreffen.

Gemäß Figur 5a ist die Oberseite des strahlungsdurchlässigen Körpers 3 stellenweise mit einer reflektierenden Schicht 11 versehen. Die reflektierende Schicht 11 ist dabei mittels der Formgebung des Körpers 3 paraboloid ausgestaltet. Die nicht von der reflektierenden Schicht 11 bedeckte Oberfläche des Körpers 3 hat eine linsenartige Formgebung. Durch diese Ausgestaltung des Körpers 3 wird Licht, das vom Halbleiterchip 2, der als LED ausgestaltet ist, emittiert wird, entweder direkt aus dem Körper transmittiert, wobei über die linsenartige Struktur des Körpers 3 die Strahlung im Wesentlichen in Pfeilrichtung 18 emittiert wird. Licht, das auf die reflektierende Schicht 11 auftrifft, wird von dieser dann ebenfalls im Wesentlichen in Pfeilrichtung 18 umgelenkt. Auf diese Art und Weise ergibt sich eine Halbleiteranordnung 1, die Licht effektiv parallel zur Chipoberseite 22 gerichtet emittiert.

Alternativ zu dem in Figur 5a gezeigten Aufbau sind auch andere Bauformen wie in Figur 5b denkbar, wo etwa die reflektierende Schicht 11 nur im lateral mittleren Bereich über dem Halbleiterchip 2 angebracht ist, so dass rings herum die Oberseite des strahlungsdurchlässigen Körpers 3 frei bleibt. Die Strahlung wird hierdurch divergent rotationssymmetrisch im Wesentlichen lateral in Pfeilrichtung 18 abgestrahlt.

Optional kann der Halbleiterchip beispielsweise geriffelte Außenflächen aufweisen, die die Lichtaus- beziehungsweise Lichteinkopplung aus dem Halbleiterchip 2 verbessern oder auch für eine mechanisch stabilere Verbindung mit Klebeverbindung 4 oder strahlungsdurchlässigen Körper 3 sorgen. Mit derartigen Oberflächenstrukturierungen kann auch der Körper 3 versehen sein.

Gemäß Figur 6 sind mehrere Halbleiterchips 2 in Ausnehmungen 13 des strahlungsdurchlässigen Körpers 3 untergebracht. Die Halbleiteranordnung 1 weist zwei elektrische Anschlussstellen 5 auf, die SMT-kontaktierbar sind und die elektrische Kontaktierung zu einem externen nicht gezeichneten Träger, der etwa in Form einer Metallkernplatine gestaltet sein kann, aufweist. Zwischen den Halbleiterchips 2 sind elektrische Verbindungen 12 angebracht, die aus einem Metall geformt sind und wie die Anschlussstellen 5 auf die Kontaktflächen der Halbleiterchips 2 mit einem leitfähigen Kleber aufgeklebt sind. Die Verbindungen 12 weisen eine geringere Dicke als die zwei Anschlussstellen 5 auf. Durch diese Anordnung entsteht eine Reihenschaltung der Halbleiterchips 2. Der Körper 3 ist wieder linsenartig ausgestaltet. Dabei kann eine große Linse oder auch für jeden Halbleiterchip 2 eine Sublinse ausgebildet werden, je nach Erfordernissen an die Qualität der optischen Abbildung. Den Klebeverbindungen 4 können etwa verschiedene Konversionsmittel 7a, 7b, 7c beigemengt sein.

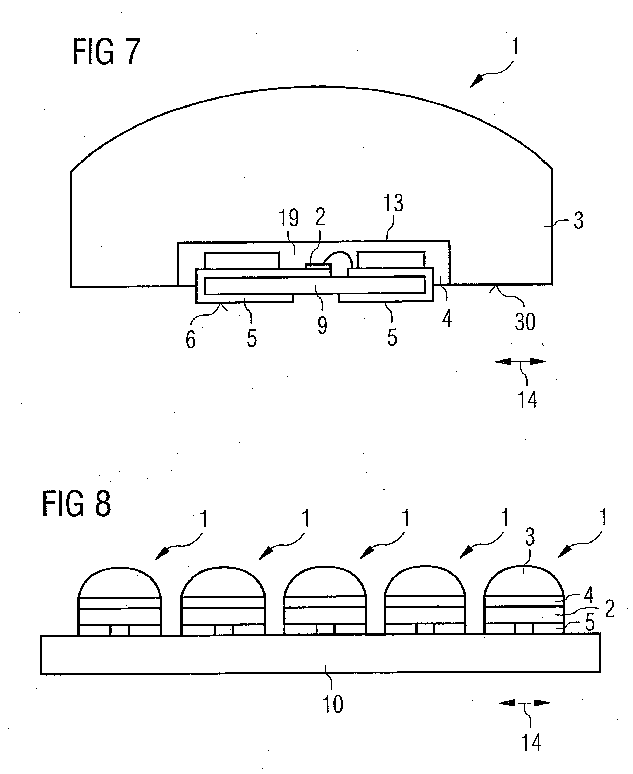

Bei der Abwandlung gemäß Figur 7 ist ein Halbleiterchip 2 auf einem Zwischenträger 9 angebracht. Der Zwischenträger 9 ist im Wesentlichen aus einer thermisch gut leitfähigen Keramik gestaltet. Die elektrischen Anschlussstellen 5 sind von der dem Halbleiterchip 2 abgewandten Seite zur dem Halbleiterchip 2 zugewandten Seite U-förmig geführt und sind SMT-kontaktierbar. Der Halbleiterchip 2 ist mit der Chipunterseite 21 direkt auf eine der Anschlussstellen 5 elektrisch leitend geklebt oder gelötet und mit einer weiteren Anschlussstelle 5 über eine Drahtverbindung verbunden. Der Halbleiterchip 2 sitzt in einer Aussparung 19 des Zwischenträgers 9, so dass der Verbindungsdraht beim Kleben beziehungsweise Einsetzen des Zwischenträgers 9 in den Körper 3 nicht beschädigt wird.

Alternativ zu dem in Figur 7 gezeigten Halbleiterchip 2, dessen elektrische Kontaktierungen an Chipoberseite 22 beziehungsweise Chipunterseite 21 befindlich sind, können auch Halbleiterchips 2 in Flip-Chip-Anordnung Verwendung finden. Auch können auf dem Zwischenträger 9 ohne größere Schwierigkeiten mehrere auch verschiedenartige, in verschiedenen Farben emittierende Halbleiterchips 2 angebracht sein. Der strahlungsdurchlässige Körper 4 kann etwa in Form einer Zylinderlinse ausgestaltet sein.

In Figur 8 sind mehrere Abwandlungen von Halbleiteranordnungen 1, aufgebaut gemäß Figur 1, auf einem thermisch leitfähigen Träger 10 arrangiert. Da die Halbleiterchips 2 bis auf den Körper 3 keine weitere Hausung aufweisen, und sich der Platzbedarf in lateraler Richtung 13 somit im Wesentlichen auf die lateralen Abmessungen des Halbleiterchips 2 beschränkt, können die Halbleiteranordnungen 1 hochdicht gepackt werden. Die im Betrieb der Halbleiterchips 2 entstehende Abwärme kann effizient über die elektrischen Anschlussstellen 5 und über den thermisch leitfähigen Träger 10 abtransportiert werden. Da, wie beschrieben, kein weiteres Gehäuse Verwendung findet, ist der thermische Kontakt von den Halbleiterchips 2 zum Träger 10 sehr gut ausgeprägt, insbesondere falls die elektrischen Anschlussstellen 5 flächig und metallisch ausgeführt sind. Via SMT können die einzelnen Halbleiteranordnungen 1 auf einfache Art und Weise am Träger 14 angebracht und dort auf entsprechend gefertigte, nicht gezeichnete Leiterbahnen leicht aufgesetzt und etwa verlötet werden.

Zur hochdichten Packung der Halbleiteranordnungen 1 ist es günstig, wenn diese in Draufsicht etwa einen quadratischen Querschnitt aufweisen. Ebenso günstige Querschnitte wären etwa kreisartige, rechteckige oder hexagonale Formgebungen. Je nach Erfordernissen können die etwa als Linsen ausgestalteten Körper 3 etwa verschiedene Konversionsmittel 7 oder Filtermittel 8 enthalten, so dass gleichartige Halbleiterchips 2 verwendet werden können und trotzdem von den einzelnen Halbleiteranordnungen 1 verschiedene Farben abgestrahlt werden, so dass sich insgesamt eine weißes Licht abstrahlende Beleuchtungseinrichtung oder eine verschiedenfarbig abstrahlende Anzeigeeinrichtung, beispielsweise in Verbindung mit einer Flüssigkristall-Maske, ergeben kann. Insbesondere über die SMT-Bauweise werden Zwischenschritte wie Wirebonding überflüssig.

## Patentansprüche

1. Oberflächenmontierbare Halbleiteranordnung (1) mit
- einer Montageseite (6),
- mindestens einem optoelektronischen Halbleiterchip (2) mit einander gegenüberliegenden Chipober- (22) und Chipunterseiten (21),
- einem zumindest teilweise strahlungsdurchlässigen Körper (3) mit einer Körperunterseite (30), an der der Halbleiterchip (2) derart angebracht ist, dass die Chipoberseite (22) der Körperunterseite (30) zugewandt ist, wobei der Halbleiterchip (2) einen quadratischen Grundriss aufweist,
- einer mindestens teilweise strahlungsdurchlässigen Klebeverbindung (4), über die der Halbleiterchip (2) und der Körper (3) miteinander verbunden sind, wobei die Chipunterseite (21) frei von der Klebeverbindung (4) ist, und
- mindestens zwei elektrischen Anschlussstellen (5) zur elektrischen Kontaktierung der Halbleiteranordnung (1), wobei der Körper (3) an der Körperunterseite (30) eine Ausnehmung (13) aufweist, in der sich der mindestens eine Halbleiterchip (2) befindet,
wobei die Anschlussstellen (5) den Körper (3) lateral nicht überragen und mit ihrer dem Halbleiterchip (2) abgewandten Seite die Halbleiteranordnung (1) an deren Montageseite (6) begrenzen,
**dadurch gekennzeichnet, dass**
eine laterale Ausdehnung des Körpers (3) um weniger als 40 % von einer lateralen Ausdehnung des Halbleiterchips (2) abweicht, und
der strahlungsdurchlässige Körper (3) einen rechteckigen Querschnitt aufweist und den Halbleiterchip (2) seitlich an nur zwei einander gegenüberliegenden Seitenflächen umgibt.

2. Halbleiteranordnung (1) nach Anspruch 1, dessen Anschlussstellen (5) SMT-kontaktierbar sind.

3. Halbleiteranordnung (1) nach einem der vorhergehenden Ansprüche,
bei der die Anschlussstellen (5) den Halbleiterchip (2) lateral nicht überragen.

4. Halbleiteranordnung (1) nach einem der vorhergehenden Ansprüche,
bei der sich die Anschlussstellen (5) direkt an der Chipunterseite (21) befinden, parallel zu dieser ausgerichtet und flächig ausgestaltet sind.

5. Halbleiteranordnung (1) nach einem der vorhergehenden Ansprüche,
bei der die laterale Ausdehnung des Körpers (3) um weniger als 10 % von der lateralen Ausdehnung des Halbleiterchips (2) abweicht.

6. Halbleiteranordnung (1) nach einem der vorhergehenden Ansprüche,
bei der die Chipunterseite (21) frei zugänglich ist.

7. Halbleiteranordnung (1) nach einem der vorhergehenden Ansprüche,
bei der die Anschlussstellen (5) in lateraler Richtung (14) bündig mit dem Halbleiterchip (2) abschließen.

## Claims

1. A surface-mountable semiconductor arrangement (1) comprising
- a mounting side (6),
- at least one optoelectronic semiconductor chip (2) having mutually opposite chip top (22) and chip bottom sides (21),
- an at least partially radiation-transmissive body (3) having a body underside (30) on which the semiconductor chip (2) is arranged such that the chip top side (22) faces the body underside (30), wherein the semiconductor chip (2) has a square base area,
- an at least partially radiation-transmissive adhesive connection (4) via which the semiconductor chip (2) and the body (3) are connected to one another, wherein the chip bottom side (21) is free of the adhesive connection (4), and
- at least two electrical connection points (5) for electrically contacting the semiconductor arrangement (1), wherein the body (3) comprises a recess (13) on the body underside (30) in which recess the at least one semiconductor chip (2) is located,
wherein the connection points (5) do not project laterally beyond the body (3) and limit the semiconductor arrangement (1) on its mounting side (6) with their side facing away from the semiconductor chip (2),
**characterized in that**
a lateral extent of the body (3) deviates by less than 40% from a lateral extent of the semiconductor chip (2), and
the radiation-transmissive body (3) has a rectangular cross section and surrounds the semiconductor chip (2) laterally on only two mutually opposite side surfaces.

2. The semiconductor arrangement (1) according to claim 1, the connection points (5) of which are SMT-contactable.

3. The semiconductor arrangement (1) according to one of the preceding claims,
in which the connection points (5) do not project laterally beyond the semiconductor chip (2).

4. The semiconductor arrangement (1) according to one of the preceding claims,
in which the connection points (5) are located directly on the chip bottom side (21), are oriented parallel to the latter and are flat.

5. The semiconductor arrangement (1) according to one of the preceding claims,
in which the lateral extent of the body (3) deviates by less than 10% from the lateral extent of the semiconductor chip (2) .

6. The semiconductor arrangement (1) according to one of the preceding claims,
in which the bottom side (21) of the chip (21) is freely accessible.

7. The semiconductor arrangement (1) according to one of the preceding claims,
in which the connection points (5) terminate flush with the semiconductor chip (2) in the lateral direction (14).

## Revendications

1. Dispositif à semi-conducteurs montable en surface (1) comportant
- une face de montage (6),
- au moins une puce à semi-conducteurs optoélectronique (2) comportant des faces supérieure de puce (22) et inférieure de puce (21) opposées,
- un corps (3) au moins en partie perméable au rayonnement comportant une face inférieure de corps (30) sur laquelle la puce à semi-conducteurs (2) est disposée de sorte que la face supérieure de la puce (22) est orientée vers la face inférieure du corps (30), la puce à semi-conducteurs (2) présentant une forme carrée,
- une liaison adhésive (4) au moins en partie perméable au rayonnement, par l'intermédiaire de laquelle la puce à semi-conducteurs (2) et le corps (3) sont reliés, la face inférieure de la puce (21) étant dégagée de la liaison adhésive (4), et
- au moins deux points de raccordement électrique (5) pour la mise en contact électrique du dispositif à semi-conducteurs (1),
le corps (3) présentant sur la face inférieure du corps (30) un évidement (13) dans lequel se trouve ladite au moins une des puces à semi-conducteurs (2),
les points de raccordement (5) ne surplombant pas le corps (3) latéralement et limitant le dispositif à semi-conducteurs (1) sur sa face de montage (6) par leur face détournée de la puce à semi-conducteurs (2),
**caractérisé en ce que**
une extension latérale du corps (3) diverge de moins de 40 % d'une extension latérale de la puce à semi-conducteurs (2), et **en ce que**
le corps (3) perméable au rayonnement présente une section rectangulaire et n'entoure la puce à semi-conducteurs (2) latéralement que sur deux faces latérales opposées.

2. Dispositif à semi-conducteurs (1) selon la revendication 1, dont les points de raccordement (5) peuvent être mis en contact par CMS.

3. Dispositif à semi-conducteurs (1) selon l'une quelconque des revendications précédentes,
**caractérisé en ce que** les points de raccordement (5) ne surplombent pas la puce à semi-conducteurs (2) latéralement.

4. Dispositif à semi-conducteurs (1) selon l'une quelconque des revendications précédentes,
**caractérisé en ce que** les points de raccordement (5) se trouvent directement sur la face inférieure de la puce (21), lui sont parallèles et configurés de manière plane.

5. Dispositif à semi-conducteurs (1) selon l'une quelconque des revendications précédentes,
**caractérisé en ce que** l'extension du corps (3) diverge de moins de 10 % de l'extension latérale de la puce à semi-conducteurs (2).

6. Dispositif à semi-conducteurs (1) selon l'une quelconque des revendications précédentes,
**caractérisé en ce que** la surface inférieure de la puce (21) est accessible librement.

7. Dispositif à semi-conducteurs (1) selon l'une quelconque des revendications précédentes,
**caractérisé en ce que** les points de raccordement (5) affleurent la puce à semi-conducteurs (2) dans le sens latéral (14).
